## Europäisches Patentamt
## European Patent Office
## Office européen des brevets

(19)

(11) Veröffentlichungsnummer: **0 197 362**
**A1**

(12) # EUROPÄISCHE PATENTANMELDUNG

(21) Anmeldenummer: **86103573.1**

(22) Anmeldetag: **17.03.86**

(51) Int. Cl.⁴: **G01R 31/28**

(30) Priorität: **22.03.85 DE 3510494**

(43) Veröffentlichungstag der Anmeldung:
**15.10.86 Patentblatt 86/42**

(84) Benannte Vertragsstaaten:
**DE FR GB IT NL**

(71) Anmelder: **Siemens Aktiengesellschaft Berlin und München**
**Wittelsbacherplatz 2**
**D-8000 München 2(DE)**

(72) Erfinder: **Brust, Hans-Detlef**
**Martin-Luther-Strasse 2**
**D-6602 Dudweiler(DE)**
Erfinder: **Otto, Johann, Dipl.-Ing.**
**Pater-Hammerschmid-Strasse 4**
**D-8170 Bad Tölz(DE)**

(54) **Verfahren zur Ermittlung der ein Signal einer bestimmten Signalfrequenz führenden Punkte auf einer Probe mittels eines Rastermikroskops.**

(57) Verfahren zur Ermittlung der ein Signal einer bestimmten Signalfrequenz führenden Punkte auf einer Probe (IC) mit einem Rastermikroskop, bei dem eine Gruppe von Punkten nacheinander abgetastet wird. Über breitbandige Auswerteschaltung (LI') wird bei einer relativ hohen Abtastgeschwindigkeit zunächst ermittelt, ob ein eine Signalfrequenz führender Punkt abgetastet wird. Ist das der Fall, so erfolgt eine Umschaltung auf eine niedrigere Abtastgeschwindigkeit, um in den interessierenden Bereichen der Probe (IC) mit hoher Empfindlichkeit und Ortsauflösung messen zu können.

FIG 1

EP 0 197 362 A1

Verfahren zur Ermittlung der ein Signal einer bestimmten Signalfrequenz führenden Punkte auf einer Probe mittels eines Rastermikroskops

Die Erfindung bezieht sich auf ein Verfahren zur Ermittlung der ein Signal einer bestimmten Signalfrequenz führenden Punkte auf einer Probe mittels eines Rastermikroskops nach den gleichlautenden Oberbegriffen der Patentansprüche 1 und 3 sowie auf Schaltungsanordnungen zur Durchführung des Verfahrens.

Ein Verfahren dieser Art ist in der deutschen Patentanmeldung P 34 20 272.2 vorgeschlagen worden. Dabei wird ein Korpuskularmikroskop verwendet, in dem ein Korpuskularstrahl, z.B. ein Elektronenstrahl, als Primärstrahl eine Gruppe von Punkten auf einer Probe nacheinander abtastet. Der Korpuskularstrahl wird mit einer einstellbaren Pulsfrequenz gepulst, die um den Betrag einer festen Frequenz von der bestimmten Signalfrequenz abweicht, wobei die erste Auswerteschaltung aus einem Bandpaßfilter mit einem schmalen Durchlaßbereich, dessen Mittenfrequenz der festen Frequenz entspricht, und einem nachfolgenden Demodulator besteht.

Ein weiteres Verfahren dieser Art ist aus den Proc. of Journée d' Electronique, 1983 "Testing Complex Integrated Circuits: A Challenge" herausgegeben von dem Swiss Federal Institute of Technology, Lausanne, Schweiz, S. 283-298, bekannt. Hier wird das Auffinden einer bestimmten Signalfrequenz an den Punkten einer integrierten Schaltung unter Verwendung eines Rasterelektronenmikroskops und eines als erste Auswerteschaltung dienenden "Lock-in-Verstärkers" durchgeführt. Dabei wird aus einem an einem Punkt gewonnenen Potentialkontrastsignal mit Hilfe des "Lock-in"-Verstärkers ein Signal mit der gesuchten Signalfrequenz ausgefiltert und dann die Intensität dieses Signals als Helligkeitsschwankung auf der Bildröhre des Mikroskops dargestellt.

Bei den vorstehend erwähnten Verfahren ist die maximale Geschwindigkeit, mit der eine Gruppe von Punkten auf der Probe nacheinander abgetastet werden kann, durch die Bandbreite der ersten Auswerteschaltung begrenzt. Für eine schnelle Messung, die auch im Hinblick auf eine möglichst geringe Belastung der Probe durch den Elektronenstrahl wünschenswert ist, muß diese Bandbreite möglichst groß sein. Zugleich sinkt mit steigender Bandbreite aber die Empfindlichkeit des Verfahrens, da sich das Signal-Rausch-Verhältnis des Ausgangssignals der ersten Auswerteschaltung verschlechtert. Daher muß hier zur Erzielung einer kurzen Meßzeit eine Reduzierung der Empfindlichkeit oder der Ortsauflösung der abgetasteten Punkte auf der Probe in Kauf genommen werden.

Der Erfindung liegt die Aufgabe zugrunde, ohne Verschlechterung der Ortsauflösung und Empfindlichkeit eine Verringerung der für die Abtastung der Probenoberfläche oder eines Teiles derselben benötigte Meßzeit herbeizuführen. Das wird erfindungsgemäß durch eine Ausbildung des eingangs genannten Verfahrens nach dem kennzeichnenden Teil des Anspruchs 1 erreicht. Gemäß weiterer Erfindung wird die Aufgabe auch bei einer Ausbildung des eingangs genannten Verfahrens nach dem kennzeichnenden Teil des Anspruchs 3 erreicht.

Der mit der Erfindung erzielbare Vorteil liegt insbesondere darin, daß nur diejenigen Teile, z. B. Leiterbahnen, der Probenoberfläche, die die gesuchte Signalfrequenz führen, mit relativ geringer Geschwindigkeit und damit hoher Empfindlichkeit und Ortsauflösung abgerastert werden, während die übrigen Teile mit erhöhter Geschwindigkeit abgetastet werden. Daher verringert sich die Meßzeit erheblich, ohne daß die Ortsauflösung oder die Empfindlichkeit des Verfahrens verringert werden.

Die Erfindung wird nachfolgend anhand der Zeichnung näher erläutert. Dabei zeigen:

Fig. 1 eine erste Anordnung zur Durchführung des erfindungsgemäßen Verfahrens,

Fig. 2 eine zweite Anordnung zur Durchführung des erfindungsgemäßen Verfahrens,

Fig. 3 eine Weiterbildung der Anordnung nach Fig. 2, die auch für Fig. 1 von Bedeutung ist, und

Fig. 4 eine Teilschaltung der Anordnung nach den Figuren 1 bis 3.

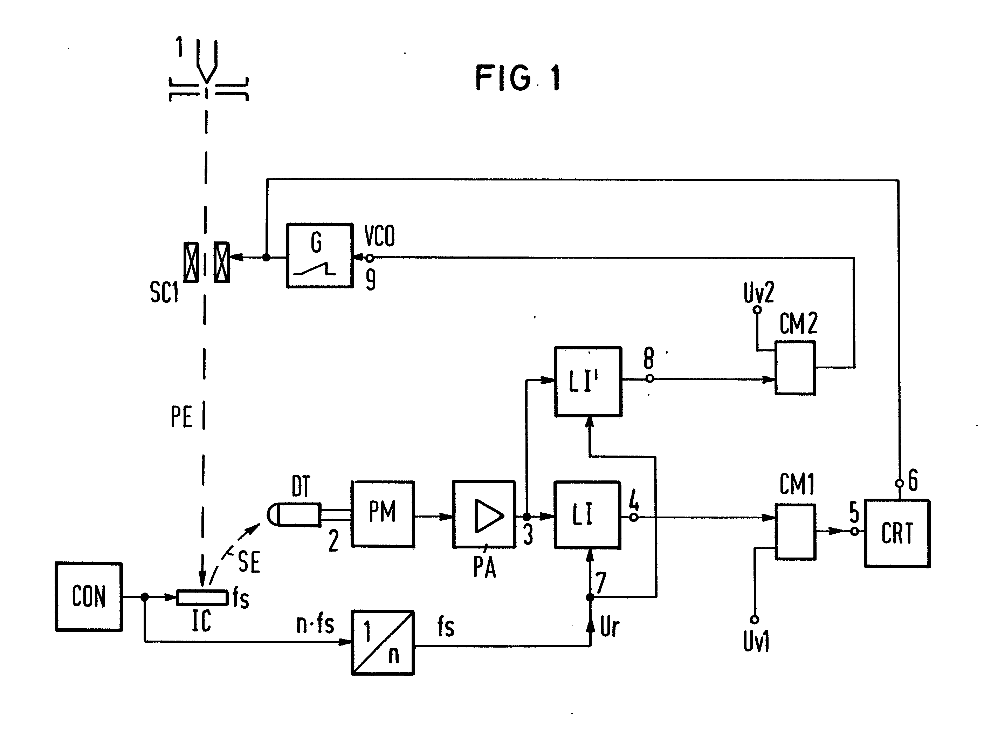

Bei der Anordnung nach Fig. 1 bilden die aus einer Elektronenquelle 1 eines Rasterelektronenmikroskops austretenden Elektronen einen Primärstrahl PE. Dieser trifft auf einen Punkt einer Probe IC, z.B. eines zu untersuchenden integrierten Schaltkreises, und löst dort Sekundärelektronen SE aus. Diese werden in einem Detektor DT nachgewiesen. In Abhängigkeit von dem Sekundärelektronenstrom, der auf den Detektor DT auftrifft, werden in diesem Lichtimpulse erzeugt, die einem Fotomultiplier PM über einen Lichtleiter 2 zur Abgabe eines sekundären elektrischen Signals zugeführt werden. Das sekundäre elektrische Signal wird nach einer Verstärkung in einem Vorverstärker PA dem Eingang 3 einer ersten Auswerteschaltung LI zugeführt, die als "Lock-in"-Verstärker ausgebildet ist. Das bei 4 auftretende Ausgangssignal von LI gelangt zu einem Komparator CM1, der mit einer insbesondere einstellbaren Vergleichsspannung Uv1 beaufschlagt ist. Übersteigt das Ausgangssignal von LI den Wert von Uv1, so wird es vom Ausgang des Komparators CM1 an den Intensitätssteuereingang 5 einer Bildröhre CRT gelegt. Der Elektronenstrahl der Bildröhre wird über x-und y-Ablenkeinrichtungen positioniert, die über einen (zweipoligen) Eingang 6 von den von einem Rastergenerator G erzeugten Ablenkspannungen beeinflußt werden. Da G mit diesen Ablenkspannungen auch die mit SC1 angedeuteten Ablenksysteme für den Primärstrahl PE beeinflußt, erfolgt eine Ablenkung von PE über eine Gruppe von Punkten auf der Probe IC, die der Ablenkung des Elektronenstrahls über den Bildschirm von CRT über eine Gruppe von zugeordneten Bildpunkten entspricht.

Die integrierte Schaltung IC wird von einer Ansteuerung CON aus mit einem Signal der Frequenz n x fs angesteuert. Dieses Signal wird zusätzlich über einen Frequenzteiler, der n x fs auf eine Frequenz fs teilt, der ersten Auswerteschaltung LI über deren Eingang 7 als eine Referenzspannung Ur zugeführt. Durch diese Referenzspannung Ur wird die erste Auswertesschaltung LI, die - schmalbandig ausgebildet ist, auf die Frequenz fs abgestimmt. Wenn nun der von PE abgetastete Punkt ein Signal der Signalfrequenz fs führt, enthält auch das über DT und PM abgeleitete sekundäre elektrische Signal, das am Eingang 3 von LI anliegt, einen Signalanteil mit der Frequenz fs. LI selektiert und demoduliert diesen Signalanteil, wobei das Ausgangssignal von LI die Intensität des Elektronenstrahls der Bildröhre CRT steuert.

In Fig. 1 ist eine zweite Auswerteschaltung LI' vorgesehen, die entsprechend der Auswerteschaltung LI aber wesentlich breitbandiger ausgebildet ist als diese.

LI' liegt mit seinem Eingang am Schaltungspunkt 3 und ist somit der Auswerteschaltung LI eingangsseitig parallel geschaltet. Das bezieht sich auch auf den Referenzsignaleingang von LI', der mit dem Schaltungspunkt 7 verbunden ist. Das am Ausgang 8 von LI' auftretende Ausgangssignal gelangt zu einem Komparator CM2, der mit einer insbesondere einstellbaren Vergleichsspannung Uv2 beaufschlagt ist. Übersteigt das Ausgangssignal von LI' den Wert von Uv2, so gelangt es an einen Steuereingang 9 des Rastergenerators G.

Nach dem erfindungsgemäßen Verfahren tastet der Primärstrahl PE entsprechend der Ansteuerung der Ablenksysteme SC mittels des Rastergenerators G eine Gruppe von Punkten auf der Probe IC mit einer ersten Abtastgeschwindigkeit ab. Diese Punkte können beispielsweise auf einer Zeile oder auf einer Vielzahl von parallelen Zeilen liegen, die die gesamte Probenoberfläche überdecken. Führt der jeweils abgetastete Punkt ein Signal mit der Frequenz fs, so entsteht am Ausgang 8 der über die Referenzspannung Ur auf fs abgestimmten, breitbandigen Auswerteschaltung LI' ein Ausgangssignal, das beim Überschreiten eines durch Uv2 gegebenen Schwellwertes zum Steuereingang 9 des Rastergenerators G gelangt und diesen von der ersten Abtastgeschwindigkeit auf eine niedrigere zweite Abtastgeschwindigkeit umschaltet. Damit wird am Ausgang 4 von LI ein Ausgangssignal erhalten, das bei der niedrigeren, zweiten Abtastgeschwindigkeit gewonnen wird. Dieses wird im dargestellten Beispiel zur Helligkeitsmodulation der Bildröhre CRT verwendet, so daß die die Signalfrequenz fs führenden Punkte auf dem Bildschirm CRT durch ihre Helligkeit hervorgehoben werden.

Die zweite Auswerteschaltung LI' dient nur dazu, festzustellen, wann ein Signal der Signalfrequenz fs auf der Probe IC detektiert wird und beim Auftreten eines solchen Signals die Umschaltung von G auf die niedrigere, zweite Abtastgeschwindigkeit zu veranlassen. Hierdurch kann die erste Abtastgeschwindigkeit so hoch gewählt werden, daß die nicht interessierenden Bereiche auf der Probe IC, die das gesuchte Signal der Signalfrequenz fs nicht führen, schnell abgetastet werden. Diese hohe Abtastgeschwindigkeit, die eine genaue Ermittlung der signalführenden Punkte mit befriedigender Ortsauflösung und Empfindlichkeit überhaupt nicht gestatten würde, wird beim Erreichen der interessierenden Bereiche auf der Probe, in denen sich die gesuchten signalführenden Punkte befinden, durch eine langsame, für die genaue Ermittlung dieser Punkte notwendige Abtastgeschwindigkeit ersetzt. Nach dem Verlassen der interessierenden Bereiche ist dann auch das Ausgangssignal von LI' wieder verschwunden, so daß der Rastergenerator G auf die erste, größere Abtastgeschwindigkeit rückgeschaltet wird. Durch Änderung der Frequenz des Referenzsignals Ur kann der interessierende Signalfrequenzbereich systematisch abgesucht werden.

Nach einer anderen Ausgestaltung der Anordnung nach Fig. 1 kann die erste Auswerteschaltung LI in ihrer Bandbreite veränderbar sein. Hierbei arbeitet sie zunächst in einem breitbandigen Betriebsmodus, wobei der Rastergenerator G auf eine erste Abtastgeschwindigkeit eingestellt ist. Während des Auftretens eines Ausgangssignals am Ausgang 4 bzw. 5 wird dann von dort ein Eingang von LI angesteuert, über den eine Umschaltung der Auswerteschaltung in ihren schmalbandigen Betriebsmodus vorgenommen wird. Gleichzeitig ist dann auch der Ausgang 4 bzw. 5 mit dem Eingang 9 von G verbunden, so daß G durch das Ausgangssignal an 4 bzw. 5 auf die niedrigere, zweite Abtastgeschwindigkeit umgeschaltet wird. Die Umschaltung der Abtastgeschwindigkeit kann dabei sowohl in diskreten Schritten als auch kontinuierlich erfolgen. Die weitere Auswertung des Ausgangssignals von LI erfolgt in der bereits beschriebenen Weise.

Die "Lock-in"-Verstärker LI und LI' sind als solche bekannt und können z.B. aus Ithako-Verstärkern des Typs 391A bestehen. LI kann z.B. eine Bandbreite von 100 Hz aufweisen, LI' eine solche von 1 kHz Das Rasterelektronenmikroskop kann z.B. aus dem ETEC-Autoscan II bestehen. Ein Gerät dieser Art ist beispielsweise aus der US-Patentschrift 4 277 679 bekannt.

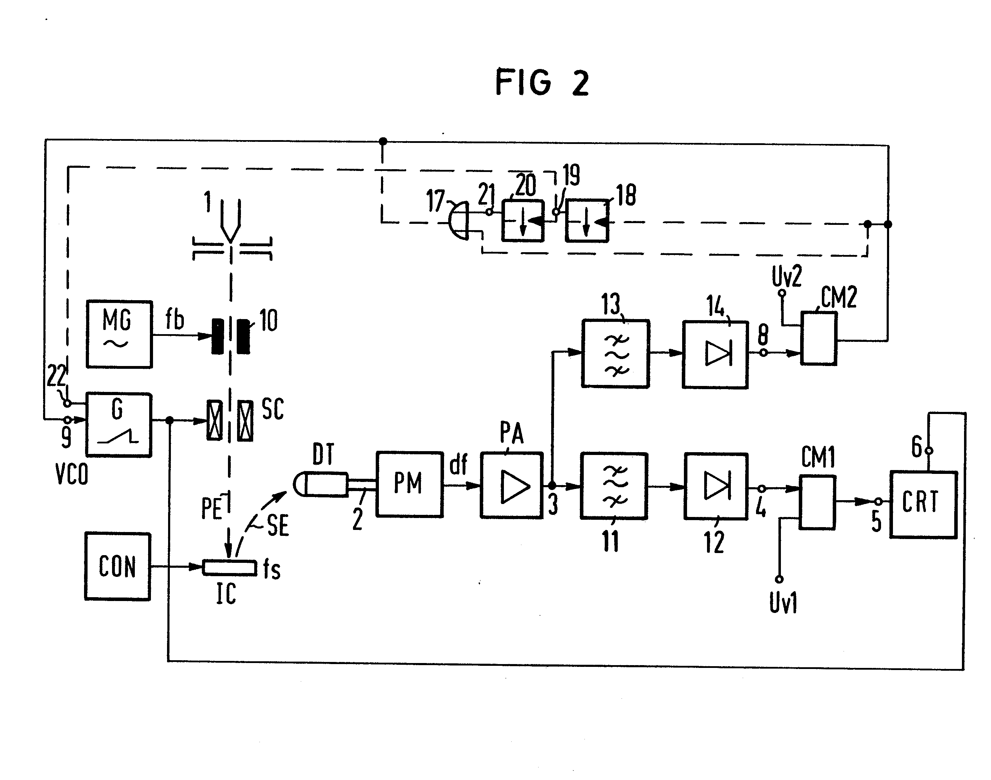

Fig. 2 zeigt eine weitere Schaltungsanordnung, die zur Durchführung des erfindungsgemäßen Verfahrens geeignet ist. Hier kann ein Rasterelektronenmikroskop verwendet werden, wie es z.B. aus der US-Patentschrift 4 223 220 bekannt ist. Die bereits anhand von Fig. 1 beschriebenen Schaltungsteile sind in Fig. 2 mit denselben Bezugszeichen versehen. Im Unterschied zu Fig. 1 wird der Primärstrahl PE mittels eines Modulationssystems 10 in seiner Intensität moduliert. Ein geeignetes Modulationssystem ist beispielsweise aus der US-Patentschrift 4 169 229 bekannt. Es wird von einem Modulationsgenerator MG mit einer Modulationsfrequenz fb angesteuert, die gegenüber der bestimmten Signalfrequenz fs, die ein gesuchter Punkt auf der Probe IC aufweisen soll, um einen Betrag df versetzt ist. Ein auf der Probe angetroffenes Signal der Signalfrequenz fs mischt sich mit der Frequenz fb, mit der PE intensitätsmoduliert ist, zu einem Zwischenfrequenzsignal der festen Frequenz df. Damit weist das sekundäre elektrische Signal, das am Schaltungspunkt 3 anliegt, einen Signalanteil der festen Frequenz df auf. Die erste Auswerteschaltung besteht hier aus einem schmalbandigen Bandpaß 11 und einem diesem nachgeschalteten Amplitudendemodulator 12. Die zweite Auswerteschaltung wird aus einem breitbandigen Bandpaß 13 und einem diesem nachgeschalteten Amplitudendemodulator 14 gebildet. Beide Bandpässe 11 und 13 sind auf die Frequenz df abgestimmt. Der von dem Bandpaß 11 an den Ausgang 4 übertragene Signalanteil wird in 12 demoduliert, wobei jedes Uv1 übersteigende Signal eine Helligkeitsmodulation des jeweiligen Bildpunktes auf der Bildröhre CRT bewirkt. Das sekundäre elektrische Signal wird andererseits auch über den breitbandigen Bandpaß 13 selektiert, in 14 demoduliert und bewirkt ein Ausgangssignal am Ausgang 8, das beim Überschreiten einer Spannungsschwelle Uv2 dem Steuereingang 9 von G zugeführt wird und zur Umschaltung des letzteren von einer ersten, relativ hohen Abtastgeschwindigkeit auf eine niedrigere, zweite Abtastgeschwindigkeit dient.

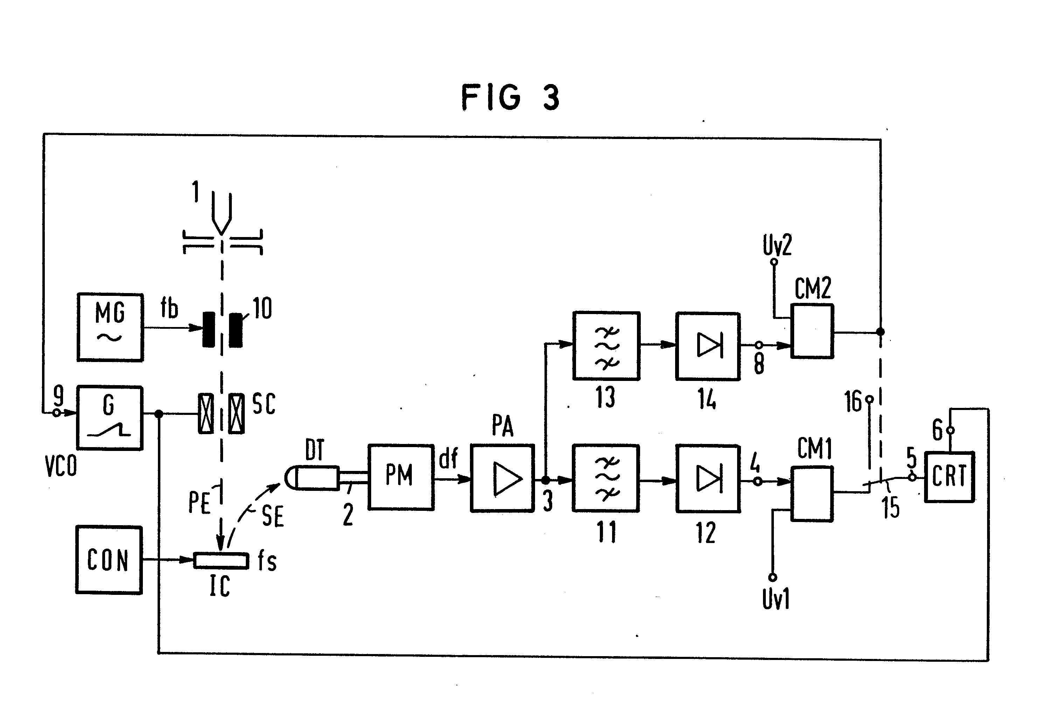

Fig. 3 zeigt eine Weiterbildung der Anordnung nach Fig. 2, bei der am Ausgang 4 der ersten Auswerteschaltung 11, 12 in der gezeichneten Lage eines Umschalters 15, wie bisher beschrieben, dem Intensitätssteuereingang 5 der Bildröhre CRT zugeführt wird. In dieser Schaltstellung wird 15 aber nur während des Auftretens eines Ausgangssignals am Ausgang 8 der zweiten Auswerteschaltung 13, 14 gehalten. Tritt bei 8 kein Ausgangssignal auf, so wird ein am Anschluß 16 liegendes Signal dem Eingang 5 zugeführt. Hierbei kann es sich z.B. um das Ausgangssignal der breitbandigen Auswerteschaltung 13, 14 oder um ein aus dem sekundären elektrischen Signal abgeleitetes Topographiesignal handeln, das insbesondere in abgeschwächter Form zugeführt wird. Wie ein solches Topographiesignal gewonnen wird, ist z.B. dem Buch von L. Reimer und G. Pfefferkorn): Raster-Elektronenmikroskopie (Springer-Verlag, Berlin, 2.Auflage, 1977) Seiten 1-3 und 109-130 zu entnehmen.

Die vorstehend beschriebene Weiterbildung der Anordnung nach Fig. 2 kann auch bei der Anordnung nach Fig. 1 eingesetzt werden.

Nach einer anderen bevorzugten Weiterbildung der Anordnung nach Fig. 2 kann der Ausgang 8 der zweiten Auswerteschaltung 14 auch mit dem ersten Eingang eines ODER-Gatters 17 verbunden sein, dessen Ausgang dann an den Steuereingang 9 von G geführt ist. In diesem Fall ist der Ausgang 8 auch mit dem Takteingang eines Monoflops 18 beschaltet, dessen Ausgang 19 mit dem Takteingang eines zweiten Monoflops 20 verbunden ist. Dessen Ausgang 21 liegt an einem zweiten Eingang des ODER-Gatters 17. Der Ausgang 19 ist schließlich mit einem zweiten Steuereingang 22 von G verbunden, über den die Abtastrichtung bei der Abtastung der Punkte auf der Probe IC umgekehrt werden kann. Sobald ein Ausgangssignal der breitbandigen Auswerteschaltung 13, 14 erhalten wird, kippt das Monoflop 18 um und liefert über 19 ein Signal, das am Eingang 22 eine Umkehrung der Abtastrichtung des Primärstrahls PE und ebenso eine Umkehr der Laufrichtung des Elektronenstrahls der Bildröhre CRT bewirkt. Die Länge des von 18 abgegebenen Signals bestimmt dabei das Ausmaß des sich für den Primärstrahl PE und den Elektronenstrahl von CRT ergebenden Rücksprungs. Dieser Rücksprung wird zweckmäßigerweise mit der hohen Abtastgeschwindigkeit vorgenommen. Nach Beendigung des Rücksprungs werden PE und der Elektronenstrahl von CRT wieder in Vorwärtsrichtung abgelenkt, wobei das durch die Rückflanke des von 19 abgegebenen Signals gekippte Monoflop 20 innerhalb seiner Eigenzeit über 21 ein Signal abgibt, das dem Steuereingang 9 zugeführt wird und eine langsame Abtastgeschwindigkeit bewirkt, auch wenn durch den Rücksprung am Ausgang 8 kein Ausgangssignal mehr vorhanden ist. Durch diese Weiterbildung kann verieden werden, daß der Primärstrahl PE infolge seiner relativ hohen Abtastgeschwindigkeit beim Erreichen derjenigen Teile der Probe IC, in denen die Signalfrequenz fs geführt wird, die Grenzen dieser Teile in der Darstellung auf dem Bildschirm des CRT nur ungenau wiedergibt. Diese Anordnung läßt sich auch mit einer Anordnung mit nur einer Auswerteschaltung sowie mit der Anordnung nach Fig. 1 (u.U. ebenfalls nur mit einer Auswerteschaltung) kombinieren.

Auch bei der Anordnung nach Fig. 2 bzw. Fig. 3 kann die zweite Auswerteschaltung 13, 14 entfallen, wenn dafür die erste Auswerteschaltung 11, 12 in ihrer Bandbreite veränderbar ist. In diesem Fall arbeitet die Auswerteschaltung 11, 12 zunächst in einem breitbandigen Betriebsmodus, wobei G auf eine erste, relativ hohe Abtastgeschwindigkeit eingestellt ist. Während des Auftretens eines Ausgangssignals am Ausgang 4 bzw. 5 wird dann ein Steuereingang des Bandpasses 11, 12 mit diesem Signal belegt, wodurch eine Umschaltung von 11, 12 in den schmalbandigen Betriebsmodus erfolgt. Gleichzeitig wird auch der Steuereingang 9 von G mit diesem Signal belegt, so daß G auf die niedrigere, zweite Abtastgeschwindigkeit umgeschaltet wird. Die Umschaltung der Bandbreite und Abtastgeschwindigkeit kann auch hier wieder sowohl in diskreten Schritten als auch kontinuierlich erfolgen.

Nach einer bevorzugten Ausgestaltung des Verfahrens nach der Erfindung können die während einer ersten schnellen Abtastsequenz erhaltenen Ausgangssignale der zweiten Auswerteschaltung LI' bzw. 13, 14 auch zwischengespeichert werden, z.B. in dem Speicher eines Rechners, wobei dann mit Hilfe der ersten, - schmalbandigen Auswerteschaltung LI bzw. 11, 12 in einer zweiten langsamen Abtastsequenz in den Bereichen, in denen bei der schnellen Abtastsequenz Ausgangssignale erhalten wurden, eine genaue Auswertung durch die Ausgangssignale der ersten Auswerteschaltung vorgenommen wird.

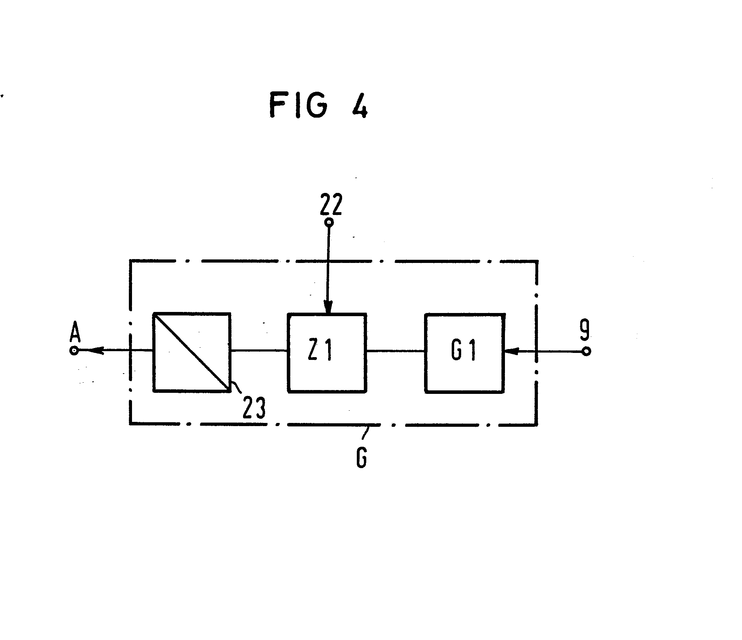

Fig. 4 zeigt eine zweckmäßige Teilschaltung des Rastergenerators G. Diese besteht aus einem Taktoszillator G1, der durch ein an dem Eingang 9 anliegendes Signal in seiner Taktfrequenz beeinflußt wird. Man kann G1 auch als einen VCO (Voltage Controlled Oscillator) bezeichnen. Ein nachgeschalteter Zähler Z1 zählt die von G1 abgegebenen Taktimpulse, wobei über einen Digital-Analog-Wandler 23 ein dem jeweiligen Zählergebnis amplitudenmäßig entsprechendes analoges Signal abgeleitet wird. Dieses stellt dann bei periodischer Rücksetzung von Z1 auf einen Anfangswert eine sägezahnförmgie Ablenkspannung dar, die über die Ausgang A abgegeben wird. Zur Umkehrung der Abtastrichtung wird dem Eingang 22 ein Signal zugeführt, das die Zählrichtung von Z1 umkehrt. Zweckmäßigerweise enthält der Rastergenerator G für die Erzeugung der x-Ablenkspannung und der y-Ablenkspannung jeweils eine Schaltung der in Fig. 4 gezeigten Art.

Im Rahmen der Erfindung können zum Abtasten der Probe IC in Abweichung von den in den Figuren dargestellten Anordnungen auch andere Rastermikroskope verwendet werden, so z.B. ein Laserscanner oder ein SAM (Scanning Acoustic Microscope).

In Abwandlung der Anordnung nach Fig. 1 kann die Referenzspannung der Frequenz fs auch in anderer Weise als dargestellt gewonne werden, so z.B. aus einem Ausgangssignal der Probe IC. Dies ist bei integrierten Schaltungen mit internem Taktoszillator, die keine Ansteuerung mehr benötigen, empfehlenswert.

Bei den Anordnungen nach den Figuren 2 und 3 kann man die Differenzfrequenz df auch als Differenz zwischen fs oder einem Vielfachen von fs und fb oder einem Vielfachen von fb wählen. In diesem Fall entsteht die Differenzfrequenz df nicht aufgrund der Mischung der Grundschwingungen, sondern durch eine Mischung mit mindestens einer Oberschwingung. Dies kann z.B. dann von Vorteil sein, wenn das Modulationssystem nur eine stark begrenzte Bandbreite aufweist und man höherfrequente Signale fs selektieren möchte.

Die Ansteuerung CON ist bei den Anordnungen nach den Figuren 1 bis 3 nicht unbedingt erforderlich, sofern die Probe auch ohne Ansteuerung arbeiten kann. Eine Synchronisation des Referenzsignals Ur und des Signals auf der Probe ist ebenfalls nicht unbedingt erforderlich.

Bezugszeichenliste für 85 P 1364 DE

BG Abschirmgitter
DE Ablenkelektrode
DN Netzelektrode
DT Detektor
G1 Netzelektrode
GH Gehäuse
HZ Hohlzylinder
K1 / K2 halbkugelförmige Netzelektroden
L Arbeitsabstand der OL
LL Lichtleiter

OA optische Achse
OL Objektivlinse
PE Primärelektronenstrahl
PR Probe
QS virtueller Quellpunkt der SE
R1 / R2 Krümmungsradien der Netzelektroden K1 bzw. K2
SE Sekundärelektronen
SZ Szintillator
$V_B$ Spannung an BG
$V_G$ Spannung an K2
$V_E$ Spannung an G1 und K1
$V_{OE}$ Spannung an DE
$V_{DN}$ Spannung an DN
$V_{GH}$ Spannung an GH
ZP Zwischenbild der Elektronenquelle
ZS Zentrum des sphärischen Gegenfeldes

## Ansprüche

1. Verfahren zur Ermittlung der ein Signal einer bestimmten Signalfrequenz führenden Punkte auf einer Probe mittels eines Rastermikroskops, bei dem eine Gruppe von Punkten auf der Probe nacheinander von einem Primärstrahl abgetastet wird, bei dem die Abtastgeschwindigkeit mittels eines Rastergenerators und einer von diesem angesteuerten Ablenkeinrichtung bestimmt wird, bei dem von dem jeweils abgetasteten Punkt ein sekundäres elektrisches Signal, insbesondere über einen Detektor abgeleitet und einer ersten Auswerteschaltung zugeführt wird, die den Signalanteil, welcher die bestimmte Signalfrequenz aufweist, selektiert und demoduliert oder gleichrichtet, und bei dem das Ausgangssignal der ersten Auswerteschaltung zur Feststellung der das Signal der bestimmten Signalfrequenz führenden Punkte herangezogen wird, wobei die Auswerteschaltung entweder auf die bestimmte Signalfrequenz abgestimmt wird, oder bei einer Intensitätsmodulation des Primärstrahls mit einer einstellbaren Modulationsfrequenz auf eine feste Frequenz abgestimmt ist, die dem Differenzbetrag zwischen der jeweiligen Modulationsfrequenz oder einem ihrer Vielfachen und der bestimmten Signalfrequenz oder einem ihrer Vielfachen entspricht, **dadurch gekennzeichnet,** daß die erste Auswerteschaltung (LI) - schmalbandig ausgebildet ist und daß eine entsprechend der ersten, jedoch wesentlich breitbandiger ausgebildete zweite Auswerteschaltung (LI') verwendet wird, deren Ausgangssignal zur Umschaltung des Rastergenerators (G) von einer ersten auf eine niedrigere, zweite Abtastgeschwindigkeit herangezogen wird.

2. Verfahren nach Anspruch 1, **dadurch gekennzeichnet,** daß das Ausgangssignal der zweiten Auswerteschaltung (LI') während einer ersten Abtastsequenz bezüglich der Gruppe von Punkten zunächst zwischengespeichert wird und sodann während einer zweiten Abtastsequenz bezüglich dieser Gruppe zur Umschaltung des Rastergenerators von der ersten auf die zweite, niedrigere Abtastgeschwindigkeit herangezogen wird.

3. Verfahren zur Ermittlung der ein Signal einer bestimmten Signalfrequenz führenden Punkte auf einer Probe mittels eines Rastermikroskops, bei dem eine Gruppe von Punkten auf der Probe nacheinander von einem Primärstrahl abgetastet wird, bei dem die Abtastgeschwindigkeit mittels eines Rastergenerators und einer von diesem angesteuerten Ablenkeinrichtung bestimmt wird, bei dem von dem jeweils abgetasteten Punkt sekundäre elektrische Signale, insbesondere über einen Detektor, abgeleitet und einer ersten Auswerteschaltung zugeführt werden, die die Signalanteile, welche die bestimmte Signalfrequenz aufweisen, selektiert und demoduliert oder gleichrichtet, und bei dem das Ausgangssignal der ersten Auswerteschaltung zur Feststellung der das Signal der bestimmten Signalfrequenz führenden Punkte herangezogen wird, wobei die Auswerteschaltung entweder auf die bestimmte Signalfrequenz abgestimmt wird oder bei einer Intensitätsmodulation des Primärstrahls mit einer einstellbaren Modulationsfrequenz auf eine feste Frequenz abgestimmt ist, die dem Differenzbetrag zwischen der jeweiligen Modulationsfrequenz oder einem ihrer Vielfachen und der bestimmten Signalfrequenz oder einem ihrer Vielfachen entspricht, **dadurch gekennzeichnet,** daß die erste Auswerteschaltung (LI) in ihrer Bandbreite veränderbar ist und daß diese zunächst in einem breitbandigen Betriebsmodus arbeitet, wobei der Rastergenerator (G) auf eine erste Abtastgeschwindigkeit eingestellt ist, und daß während des Auftretens eines Ausgangssignals der ersten Auswerteschaltung (LI) eine Umschaltung derselben für die Dauer dieses Auftretens in einen schmalbandigen Betriebsmodus vorgenommen wird, wobei der Rastergenerator (G) für die Dauer dieser Umschaltung von der ersten auf eine niedrigere, zweite Abtastgeschwindigkeit umgeschaltet wird.

4. Verfahren nach Anspruch 3, **dadurch abgewandelt,** daß die Umschaltung der ersten Auswerteschaltung (LI) in einen schmalbandigen Betriebsmodus nicht während des Auftretens eines Ausgangssignals derselben vorgenommen wird, sondern daß während einer ersten Abtastsequenz bezüglich der Gruppe von Punkten das Ausgangssignal der ersten Auswerteschaltung (LI) zunächst zwischengespeichert wird und sodann während einer zweiten Abfragesequenz dieser Gruppe zur Umschaltung des Rastergenerators (G) auf die niedrigere, zweite Abtastgeschwindigkeit herangezogen wird.

5. Verfahren nach einem der Ansprüche 1 bis 4, **dadurch gekennzeichnet**, daß die sekundären elektrischen Signale von Sekundärkorpuskeln gebildet werden, die durch den Primärstrahl in dem jeweils abgetasteten Punkt der Probe ausgelöst werden.

6. Anordnung zur Durchführung des Verfahrens nach einem der Ansprüche 1 bis 5 mit dem Rastermikroskop, dem Rastergenerator (G) und der ersten Auswerteschaltung (LI), **dadurch gekennzeichnet**, daß die erste Auswerteschaltung (LI) - schmalbandig ausgebildet ist, daß eine entsprechend der ersten, jedoch wesentlich breitbandiger als diese ausgebildete zweite Auswerteschaltung - (LI') der ersten parallel geschaltet ist, und daß das Ausgangssignal der zweiten Auswerteschaltung - (LI') einem Steuereingang des Rastergenerators zur Umschaltung auf die niedrigere, zweite Abtastgeschwindigkeit zuführbar ist.

7. Anordnung zur Durchführung des Verfahrens nach einem der Ansprüche 3 bis 5 mit dem Rastermikroskop, dem Rastergenerator (G) und der ersten Auswerteschaltung (LI), **dadurch gekennzeichnet**, daß diese in ihrer Bandbreite veränderbar ausgebildet ist und daß der Ausgang der ersten Auswerteschaltung (LI) mit einem Steuereingang zur Umschaltung ihrer Bandbreite sowie mit einem Steuereingang des Rastergenerators - (G) zur Umschaltung auf die niedrigere, zweite Abtastgeschwindigkeit verbunden ist.

8. Anordnung nach Anspruch 6 oder 7, **dadurch gekennzeichnet**, daß wenigstens eine der Auswerteschaltungen aus einem Lock-in-Verstärker (LI) besteht, der auf die Frequenz eines ihm zugeführten Referenzsignals abgestimmt wird.

9. Anordnung nach Anspruch 6 oder 7, **dadurch gekennzeichnet**, daß wenigstens eine der Auswerteschaltungen aus einem insbesondere abstimmbaren Bandpaß (13) und einem nachgeschalteten Demodulator, insbesondere Amplitudendemodulator (14), besteht.

10. Anordnung nach einem der Ansprüche 6 bis 9, **dadurch gekennzeichnet**, daß der ersten Auswerteschaltung (LI) eine erste Schwellwertschaltung mit einem Komparator (CM1) und einer diesem zugeführten ersten Vergleichsspannung nachgeschaltet ist.

11. Anordnung nach einem der Ansprüche 6, 8 oder 9, **dadurch gekennzeichnet**, daß der zweiten Auswerteschaltung (LI') eine zweite Schwellwertschaltung mit einem zweiten Komparator (CM2) und einer diesem zugeführten, zweiten Vergleichsspannung nachgeschaltet ist.

12. Anordnung nach einem der Ansprüche 6 bis 11, **dadurch gekennzeichnet**, daß der Rastergenerator (G) ein den jeweils abgetasteten Punkt definierendes Positionssignal liefert, das zusammen mit dem Ausgangssignal der ersten Auswerteschaltung (LI) einer Aufzeichnungseinrichtung, insbesondere einem Rechner, zugeführt wird.

13. Anordnung nach einem der Ansprüche 6 bis 12, **dadurch gekennzeichnet**, daß der Rastergenerator (G) mit den Ablenkeinrichtungen für den Elektronenstrahl einer Bildröhre (CRT) beschaltet ist; deren Intensitätssteuereingang (5) mit dem Ausgang der ersten Auswerteschaltung (LI) verbunden ist.

14. Anordnung nach Anspruch 13, **dadurch gekennzeichnet**, daß der Intensitätssteuereingang - (5) über einen ersten Umschalter wahlweise mit dem Ausgang der ersten und der zweiten Auswerteschaltung verbindbar ist.

15. Anordnung nach Anspruch 13, **dadurch gekennzeichnet**, daß der Intensitätssteuereingang - (5) über einen zweiten Umschalter (15) wahlweise mit dem Ausgang der ersten Auswerteschaltung und mit einem Topographiesignal oder dem sekundären elektrischen Signal beschaltbar ist.

16. Anordnung nach einem der Ansprüche 6 bis 15, **dadurch gekennzeichnet**, daß der Ausgang der ersten oder zweiten Auswerteschaltung mit einem Steuereingang (9) des Rastergenerators (G) für eine zeitlich begrenzte Umkehrung der Abtastrichtung und ein sich anschließendes Rückschalten in die ursprüngliche Abtastrichtung verbunden ist, wobei zusammen mit diesem Rückschalten die Umschaltung auf die niedrigere, zweite Abtastgeschwindigkeit erfolgt.

FIG 1

FIG 2

FIG 3

# FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | ELECTRONICS INTERNATIONAL, Band 56, Nr. 10, 19. Mai 1983, Seiten 132-136, New York, US; H.-P. FEUERBAUM et al.: "Scanned electron-beam probe shows surface acoustic waves in action" * Seite 132, Abbildung 1; Seite 134, Abschnitt: "Measuring Amplitude", Teile 1,2 * | 3 | G 01 R 31/28 |
| A | IDEM | 5,8 | |
| Y | DE-B-2 553 705 (SIEMENS AG) * Spalte 3, Zeilen 33-68; Spalte 4, Zeilen 13-44; Abbildungen 1-4 * | 3 | |
| A | | 7,10 | RECHERCHIERTE SACHGEBIETE (Int. Cl.4) G 01 R H 01 J |
| A | US-A-4 420 686 (ONOGUCHI et al.) * Abbildungen 1,2; Zusammenfassung; Anspruch 5 * | 9,12, 13 | |
| A | IBM TECHNICAL DISCLOSURE BULLETIN, Band 15, Nr. 8, Januar 1973, Seiten 2547-2548, New York, US; J.J. DeSTAFENO et al.: "Display of voltage distributions on microcircuits" | | |

Der vorliegende Recherchenbericht wurde für alle Patentansprüche erstellt.

| Recherchenort DEN HAAG | Abschlußdatum der Recherche 17-06-1986 | Prüfer KAUFFMANN J. |
|---|---|---|

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82